# EUROPEAN PATENT SPECIFICATION

(11) **EP 1 819 476 B1**
(45) Date of publication and mention of the grant of the patent: **20.01.2016**
(21) Application number: 05819869.8
(22) Date of filing: 11.11.2005
(51) Int. Cl.: B23K 26/02, B41J 2/47, H01L 21/00, B23K 26/06, H01L 23/544, B23K 26/36, B23K 26/40, H01L 21/67

(54) **METHOD AND SYSTEM FOR LASER HARD MARKING**
VERFAHREN UND SYSTEM FÜR LASERHARTMARKIERUNG
PROCEDE ET SYSTEME DE MARQUAGE DUR AU LASER

(30) Priority: 11.11.2004 US 627781 P; 09.11.2005 US 270108
(43) Date of publication of application: 22.08.2007
(73) Proprietor: Electro Scientific Industries, Inc., Portland, OR 97229-5497 (US)
(72) Inventor: GU, Bo, North Andover, MA 01845 (US)
(74) Representative: Howson, Richard G.B.
(86) International application number: PCT/US2005/041143
(87) International publication number: WO 2006/053287

(56) References cited:
- JP-A- 56 067 277
- US-A- 5 003 527
- US-A1- 2003 102 291
- US-A1- 2004 144 760
- US-B1- 6 261 919
- US-B1- 6 774 340
- US-B2- 6 563 775

## Description

### BACKGROUND OF THE INVENTION

### 1. Field of the Invention

This invention relates to a system for laser hard marking according to the preamble of claim 1.

### 2. Background Art

Lasers have been used for laser marking semiconductor wafers for decades. A listing of representative patents and publications generally related to laser marking is now provided. U.S. Patent No. 5,329,090 relates to dot marking of wafers.

The following representative patent references relate to various aspects of laser marking of wafers and electronic assemblies, illumination, and inspection/reading marks: U.S. Pat. Nos. 4,522,656; 4,945,204; 6,309,943; 6,262,388; 5,929,997; 5,690,846; 5,894,530; 5,737,122; and Japanese Patent Abstract 11135390.

The following representative references provide general information on various laser marking methods and system configurations and components: "Galvanometric and Resonant Low Inertia Scanners", Montagu, in Laser Beam Scanning, Marcel-Dekker, 1985, pp. 214-216; "Marking Applications now Encompass Many Materials", Hayes, in Laser Focus World, February 1997, pp. 153-160; "Commercial Fiber Lasers Take on Industrial Markets", Laser Focus World, May 1997, pp. 143-150. Patent Publications: WO 96/16767, WO 98/53949, U.S. Pat. Nos. 5,965,042; 5,942,137; 5,932,119; 5,719,372; 5,635,976; 5,600,478; 5,521,628; 5,357,077; 4,985,780; 4,945,204; 4,922,077; 4,758,848; 4,734,558; 4,856,053; 4,323,755; 4,220,842; 4,156,124.

Published Patent Applications WO 0154854, publication date Aug. 2, 2001, entitled "Laser Scanning Method and System for Marking Articles such as Printed Circuit Boards, Integrated Circuits, and the Like" and WO 0161275, published on Aug. 23, 2001, entitled "Method and System for Automatically Generating Reference Height Data for use in a Three-Dimensional Inspection System" are both assigned to the assignee of the present invention. Both applications are hereby incorporated by reference in their entirety.

The visibility of laser marks as seen by a vision system (or by operator visual inspection) may depend on several factors including mark depth, debris, etc. which in turn depend on laser material-interaction. For certain wafer marking applications the conventional wisdom leads to relatively large marking depths which may provide for good readability, but increasing susceptibility to subsurface damage.

Wafer marking systems have long been provided by the assignee of the present invention. WaferMark.TM. system, produced by the assignee of the present invention for several years, is believed to be the first industrial laser marking system on silicon wafer. Specifications include a 120 *µ*m marking dot diameter hard marking for 300 nm wafers. This meets the SEMI standard specification M1.15. A "soft marking specification" exists for wafer back side soft marking, including marking rough surface back side wafers up to 200 mm wafer. On the "Sigma Clean" system, a backside-marking option is provided for both front and backside marking for up to 200 mm wafer.

There are roughly two kinds of laser marks currently used by the industry, namely soft marks and hard marks. Various marking systems for producing both "hard marks" and "soft marks" have been produced by the assignee of the present invention.

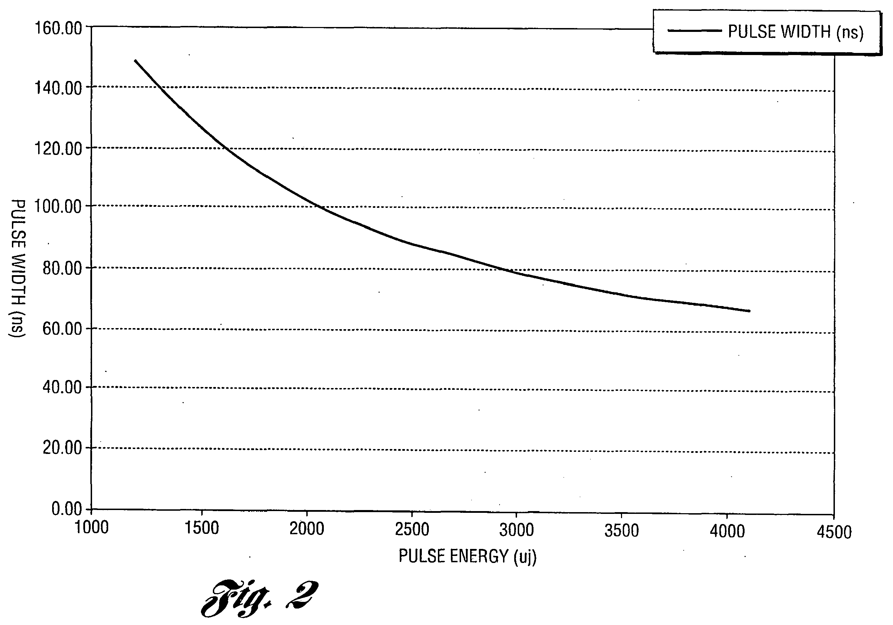

Currently, laser marking systems used for generating hard marks on wafers are provided with lasers having the following characteristic: the laser pulse width (t) varies with the laser pulse energy (E) and repetition rate (f), as shown in Figure 2. This relationship is typical of conventional q-switched and other pulsed lasers.

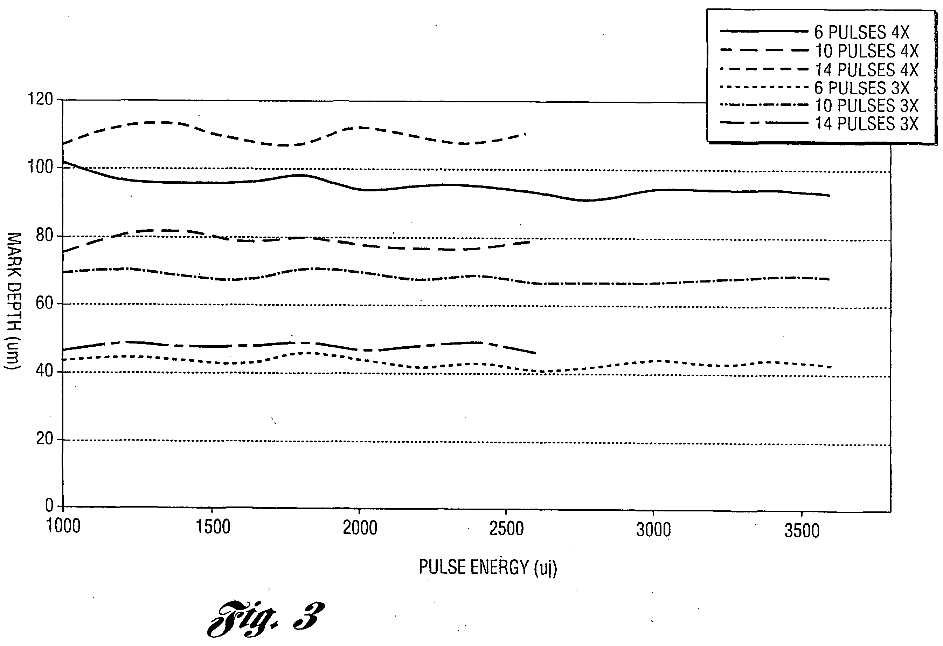

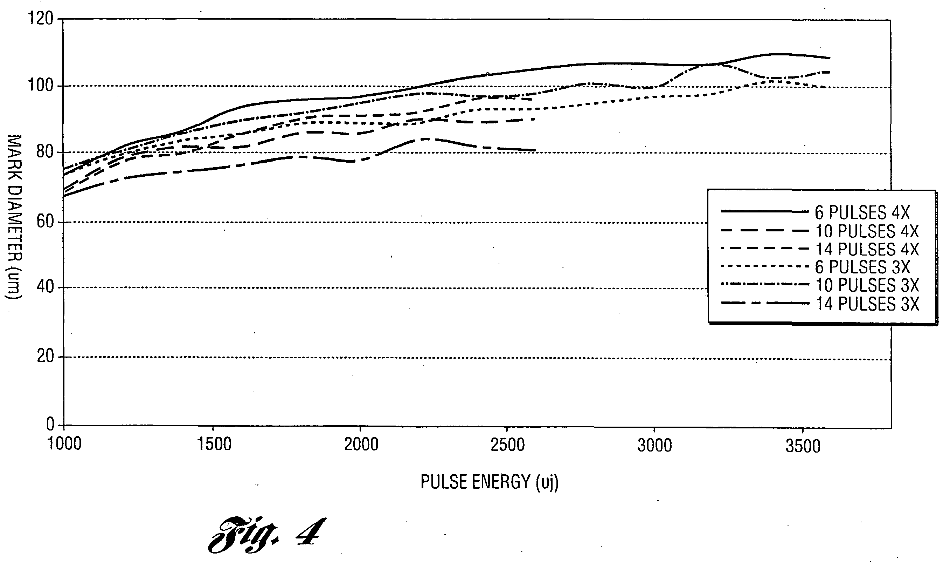

Experiments by the applicant showed that marking silicon wafers with such a conventional laser system produced the following marking process characteristics:
► The marking depth (z) depends on the number of pulses (#), but not on pulse energy (E) and little on beam expansion (n) (see Figure 3); and
► The marking dot diameter (D) depends on #, E, and n (see Figure 4).

The mutually conflicting parameters limit marking performance and introduce a tradeoff between the achievable depth, diameter, and quality of the marks. Small diameter, relatively deep, high quality marks represent a challenge and emerging requirement.

As such, it is difficult to get both the mark depth, z, and mark diameter, D, within the customer specifications simultaneously. This is because: one can only vary primarily the number of pulses, #, to obtain the required mark depth, z. If the mark quality is not acceptable at certain number of pulses, then it is very difficult, if not impossible, to get the depth associated with these numbers of pulses. If one tries to change the pulse number, #, to get better quality, the mark diameter, D, will change at the same time. Therefore, lasers utilized in current hard mark laser marking systems give little or no flexibility to improve the mark quality for certain depth and diameter combinations.

US-B1-6774340 discloses a laser-marking system as set out in the pre-characterising portion of independent claim 1.

### SUMMARY OF THE INVENTION

According to the invention, there is provided a laser-marking system for producing a hard mark on a semiconductor wafer, the system as defined in claim 1.

The object of the present invention is to provide an improved system for laser hard marking, especially for semiconductor wafers and devices.

In carrying out the above object and other objects of the present invention, a laser-marking system is provided according to claim 1.

Pulse width may be set within a range of about 1 nanosecond to about 150 nanoseconds with a typical range of about 10 nanoseconds to about 100 nanoseconds.

A typical hard mark may have a depth in a range of 10 microns to 150 microns.

The range may be 20 microns to 120 microns.

The system may further include a controller including a subsystem of electronic components and a control program that may be generally used for marking system control.

The system may further include a controller including at subsystem of electronic components and a control program that may be dedicated to control the laser subsystem.

The subsystem may include a laser having a cavity with a saturable absorber disposed therein.

The above object and other objects, features, and advantages of the present invention are readily apparent from the following detailed description of the best mode for carrying out the invention when taken in connection with the accompanying drawings.

### BRIEF DESCRIPTION OF THE DRAWINGS

FIG. 1 schematically illustrates first and second hardmarks produced within a region of a semiconductor wafer using a laser marking system of one embodiment of the present invention (simplified for illustration, not to scale);
FIG. 2 is a graph of pulse width versus pulse energy for a conventional laser;
FIG. 3 are graphs of mark depth versus pulse energy for different numbers of pulses and beam expansions for a conventional laser;
FIG. 4 are graphs of mark diameter versus pulse energy for different numbers of pulses and beam expansions for a conventional laser;
FIG. 5 is a graph of pulse width versus pulse energy of a laser of one embodiment of the invention;
FIG. 6 are graphs of mark diameter versus pulse energy for different numbers of pulses of a laser of one embodiment of the invention; and
FIG. 7 are graphs of mark depth versus pulse energy for different numbers of pulses of a laser of one embodiment of the invention.

### DETAILED DESCRIPTION OF THE PREFERRED EMBODIMENTS

Embodiments of the present invention are typically used for "dot" formats on a first side of a bare wafer, though not so limited. The wafer may be polished to a roughness standard.

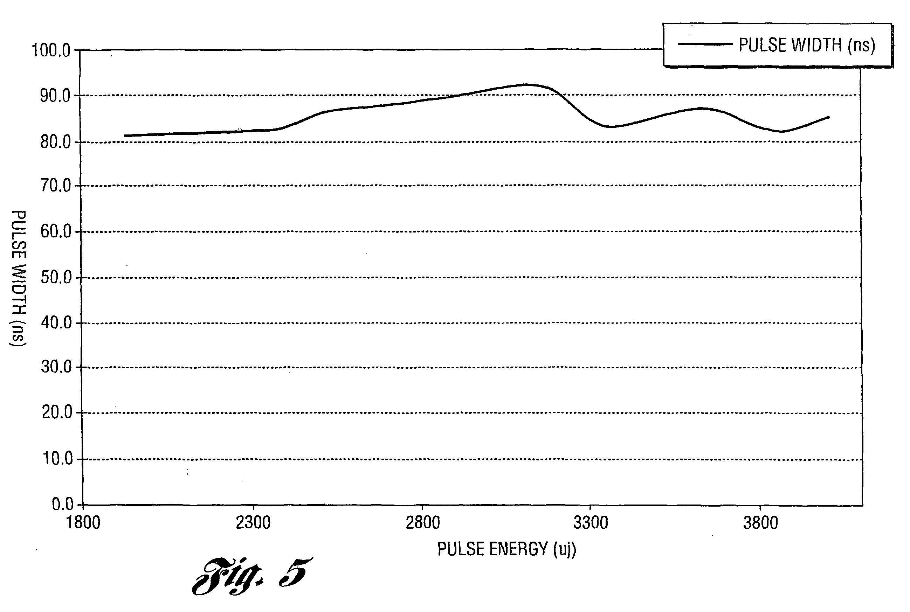

Lasers utilized in embodiments of the present invention will generally include or be configured so that the pulse width, t, is independent of E and f over the processing range, as shown in Figure 5.

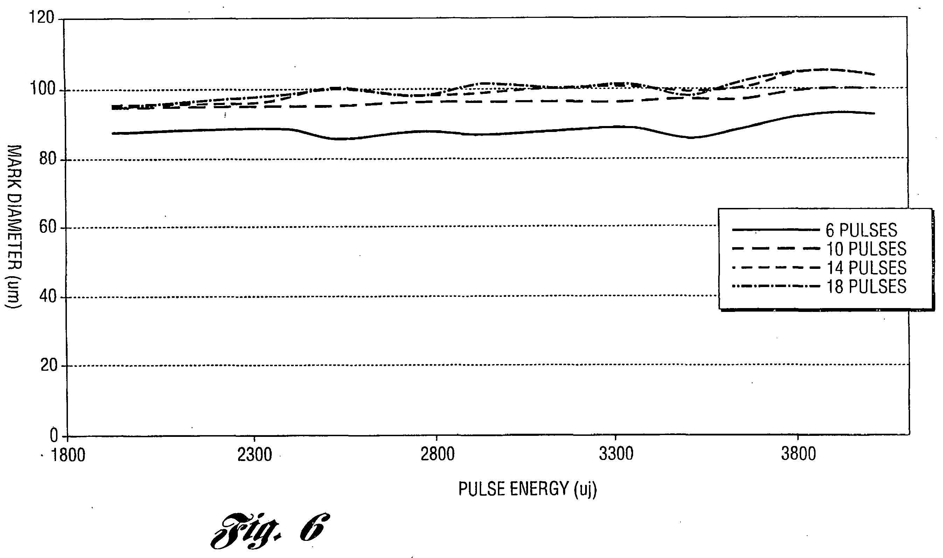

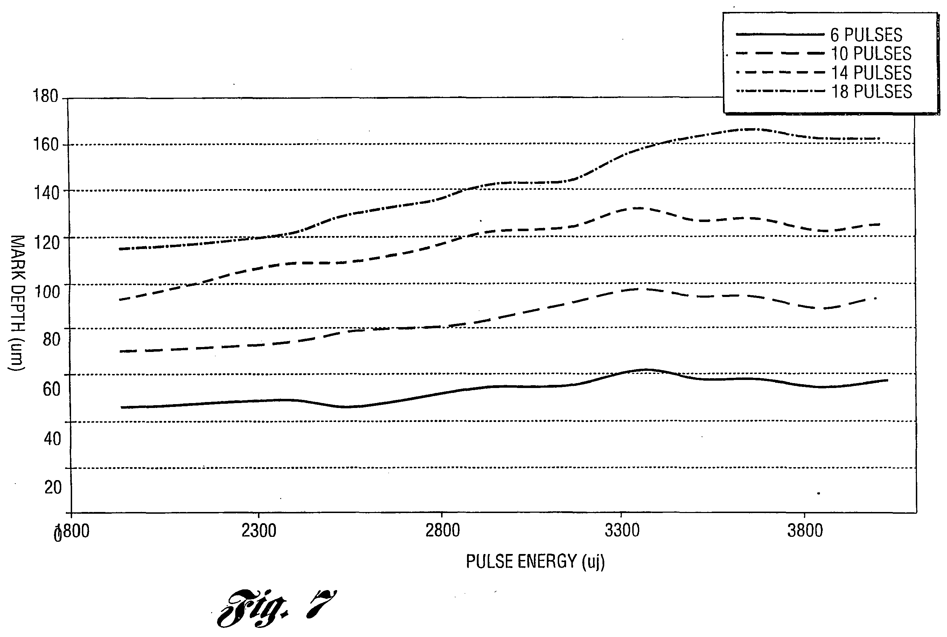

With the pulse width independent of E and f it was discovered that:
► The marking diameter (D) does not depend on pulse energy, E, but on optical expansion, n, and slightly on the number of pulses, #, (see Figure 6); and
► The marking depth (z) depends on the number of pulses, #, and pulse energy, E, (z will saturate after certain E) (see Figure 7).

Now, with an embodiment of the present invention, one can easily achieve any required combination of mark depths and diameters. First, obtain the required mark diameter, D, by selecting the proper beam expansion, n, and the number of laser pulses, #, (for the best marking quality), and then vary the laser pulse energy, E, to get the required mark depth (z) since the diameter, D, will not change with E.

Preferably the marking will occur at the position of best focus at each marking location over a marking field. However, the marking may also occur at positions other than best focus and may occur with off-normal incident marking beams. Typical marks may be about 20-120 microns deep.

There are several ways to achieve the laser characteristic shown in Figure 5.

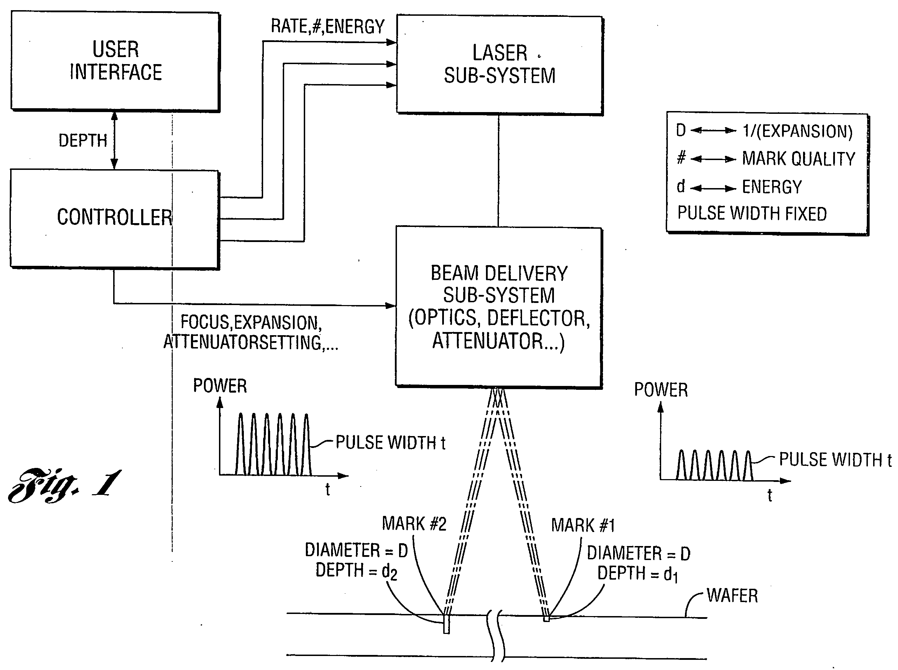

In one exemplary embodiment of a system of the present invention (*i.e*., Figure 1), one can put a saturated element in the laser cavity having an absorption coefficient that can be saturated with laser radiation, such an element is known as a "saturable absorber". Normally the absorption coefficient decreases with increasing of the resonant radiation. An absorber with similar output performance over an applicable range of laser gain and corresponding pump energy (and therefore the output energy range) will provide for a substantially constant pulse width in a q-switched system. The effective output pulse width is a function the peak and average power of the q-switched pulses. A constant pulse width can be set if the q-switch is designed such that the average pulse power and peak power is adjusted according to the corresponding pump laser power or laser gain.

In another embodiment the cavity geometry and cavity optics may be precisely adjusted to obtain constant pulse duration over the preselected energy range.

Various U.S. patents teach control of laser pulse characteristics. By way of example, the teachings of US patents 5,128,609; 5,226,051; 5,812,569, and 6,339,604 each relate to controlling laser pulse characteristics, for instance the energy and/or pulse width. The '569 and '604 patents are assigned to the assignee of the present invention. The teachings of the '609 patent, and specific embodiments disclosed in the '604 patent that relate to micromachining and laser trimming, may be adapted to form hard marks in accordance with the present invention.

In practice, a pulse temporal characteristic, for instance pulse width, may be constant for a lot or batch wafers, without a requirement for further adjustment. Future requirements may lead to setting of the pulse characteristics for hard marking different depths within a field. The surface variations of the wafers lead to a requirement for "process studies" to determine the laser output energy requirement, and such variations generally determine the frequency of such measurements. Preferably, the laser marking system will include detection and calibration hardware and software to perform any needed process studies with minimum operator intervention.

Various embodiments of the present invention may be integrated with the commercially available systems, including the Wafermark^{®} SigmaDSC™ marking products produced by the assignee of the present invention.

## Claims

1. A laser-marking system for producing a hard mark on a semiconductor wafer, the system comprising:
a beam expander;
an attenuator;
a controller including a subsystem of electronic components and a control program;
a pulsed laser subsystem including a laser having a cavity that produces a pulsed laser output for marking at a location on the wafer, the controller being operatively connected to the attenuator for controlling energy of a pulse of the pulsed laser output and
a beam delivery system for delivering the pulsed laser output to the location on the wafer, **characterised by**
the controller being operatively connected to the beam expander for producing a predetermined mark diameter; and
the pulsed laser subsystem being controlled by the controller so that output pulse width remains substantially constant with a variation in pulse repetition rate and output energy over a processing range of pulse energy.

2. The system as claimed in claim1, wherein pulse width is within a range of 10 nanoseconds to 100 nanoseconds.

3. The system as claimed in claim 1, wherein the depth of the hard mark is within a range of 10 microns to 150 microns.

4. The system as claimed in claim 3, wherein the depth of the hard mark is within a range of 20 microns to 120 microns.

5. The system as claimed in claim 1 wherein the subsystem includes a saturable absorber disposed in the cavity.

## Patentansprüche

1. Laserkennzeichnungssystem zum Erzeugen einer Hardmark-Kennzeichnung auf einem Halbleiter-Wafer, wobei das System Folgendes aufweist:
einen Strahlaufweiter;
einen Abschwächer;
eine Steuerung, die ein Subsystem aus elektronischen Komponenten und einem Steuerprogramm aufweist;
ein Impulslaser-Subsystem, aufweisend einen Laser mit einem Resonator, der einen Impulslaserausgang zum Kennzeichnen einer Stelle auf dem Wafer erzeugt, wobei die Steuerung betriebsfähig mit dem Abschwächer verbunden ist, um die Energie eines Impulses des Impulslaserausgangs zu steuern; und
ein Strahlabgabesystem zum Abgeben des Impulslaserausgangs an die Stelle auf dem Wafer,
**dadurch gekennzeichnet, dass**
die Steuerung betriebsfähig mit dem Strahlaufweiter verbunden ist, um einen vorbestimmten Durchmesser einer Kennzeichnung zu erzeugen; und
das Impulslaser-Subsystem von der Steuerung gesteuert wird, sodass die Dauer des Ausgangsimpulses im Wesentlichen konstant mit einer Schwankung der Impulswiederholungsrate und der Ausgangsenergie über einen Verarbeitungsbereich der Impulsenergie bleibt.

2. System nach Anspruch 1, wobei die Impulsdauer in einem Bereich von 10 Nanosekunden bis 100 Nanosekunden liegt.

3. System nach Anspruch 1, wobei die Tiefe der Hardmark-Kennzeichnung in einem Bereich von 10 Mikrometern bis 150 Mikrometern liegt.

4. System nach Anspruch 3, wobei die Tiefe der Hardmark-Kennzeichnung in einem Bereich von 20 Mikrometern bis 120 Mikrometern liegt.

5. System nach Anspruch 1, wobei das Subsystem einen im Resonator angeordneten sättigbaren Absorber aufweist.

## Revendications

1. Un système de marquage au laser pour produire une marque dure sur une tranche de semi-conducteur, le système comprenant:
un élargisseur de faisceau ;
un atténuateur ;
un dispositif de commande comportant un sous-système de composants électroniques et un programme de commande ;
un sous-système laser à impulsions comportant un laser qui produit une sortie laser à impulsions pour le marquage à un emplacement sur la tranche, le dispositif de commande étant relié fonctionnellement à l'atténuateur pour commander l'énergie d'une impulsion de la sortie du laser pulsé ; et
un système de délivrance de faisceau pour délivrer la sortie du laser pulsé à l'emplacement sur la tranche,
**caractérisé en ce que**
le dispositif de commande est relié fonctionnellement à l'élargisseur de faisceau pour produire un diamètre de marque prédéterminé ; et **en ce que**
le sous-système laser à impulsions est commandé par le dispositif de commande de telle sorte que la largeur d'impulsion de sortie reste sensiblement constante avec une variation du taux de répétition d'impulsion et de l'énergie de sortie dans une gamme de traitement de l'énergie d'impulsion.

2. Le système tel que revendiqué dans la revendication 1, dans lequel la largeur d'impulsion se situe dans une gamme de 10 nanosecondes à 100 nanosecondes.

3. Le système tel que revendiqué dans la revendication 1, dans lequel la profondeur de la marque dure est dans une gamme de 10 microns à 150 microns.

4. Le système tel que revendiqué dans la revendication 3, dans lequel la profondeur de la marque dure est dans une gamme de 20 microns à 120 microns.

5. Le système tel que revendiqué dans la revendication 1, dans lequel le sous-système comprend un absorbant saturable disposé dans la cavité.
